# FASCICULE DE BREVET EUROPEEN

(11) **EP 3 847 694 B1**
(45) Date de publication et mention de la délivrance du brevet: **19.06.2024**
(21) Numéro de dépôt: 19774162.2
(22) Date de dépôt: 02.09.2019
(51) Int. Cl.: H01L 23/48, H01L 21/60, H01L 23/492, H01L 25/07, H01L 25/16, H01L 23/373

(54) **MODULE ELECTRONIQUE DE PUISSANCE**
ELEKTRONISCHES LEISTUNGSMODUL
ELECTRONIC POWER MODULE

(30) Priorité: 04.09.2018 FR 1857934
(43) Date de publication de la demande: 14.07.2021
(73) Titulaire: Commissariat à l'énergie atomique et aux énergies alternatives, 75015 Paris (FR); Centre National de la Recherche Scientifique, 75794 Paris Cedex 16 (FR)
(72) Inventeur: VLADIMIROVA, Kremena, 38054 GRENOBLE CEDEX 09 (FR); CREBIER, Jean-Christophe, 38690 BEVENAIS (FR); WIDIEZ, Julie, 38054 GRENOBLE CEDEX 09 (FR)
(74) Mandataire: Brevalex
(86) Numéro de dépôt international: PCT/FR2019/052014
(87) Numéro de publication internationale: WO 2020/049245

(56) Documents cités:
- EP-A1- 2 244 288
- FR-A1- 3 028 095
- JP-A- 2005 150 596
- JP-A- 2010 239 033
- JP-A- 2011 138 851
- JP-A- 2013 058 645
- BENAISSA L ET AL: "A vertical power device conductive assembly at wafer level using direct bonding technology", POWER SEMICONDUCTOR DEVICES AND ICS (ISPSD), 2012 24TH INTERNATIONAL SYMPOSIUM ON, IEEE, 3 juin 2012 (2012-06-03), pages 77-80, XP032452770, DOI: 10.1109/ISPSD.2012.6229027 ISBN: 978-1-4577-1594-5

## Description

### DOMAINE TECHNIQUE ET ART ANTÉRIEUR

L'invention concerne le domaine de l'électronique de puissance, et notamment celui du packaging de puces semi-conductrices de puissance et de modules électroniques de puissance.

Dans le domaine de l'électronique de puissance, les modules, ou dispositifs, électroniques de puissance proposés doivent idéalement répondre à plusieurs contraintes : coûts réduits, taille réduite, forte densité de puissance, efficacité et fiabilité. Les contraintes d'utilisation de plus en plus sévères (haute tension, haute fréquence, haute température) ont conduit la communauté scientifique à se pencher sur l'exploitation de nouveaux matériaux tels que le GaN, le SiC et le diamant. Ces matériaux à grand gap permettent de repousser les limites actuelles des composants électroniques de puissance (diodes, transistors, thyristors) en silicium.

Dans un module électronique de puissance qui comporte un ou plusieurs de ces composants, un packaging adapté à ce type de composant est nécessaire pour profiter pleinement de leurs performances car les caractéristiques du packaging influencent fortement les comportements électrique et thermique ainsi que la fiabilité du module électronique de puissance.

Le packaging, également appelé package, d'un module électronique de puissance, désigne le boîtier dans lequel une ou plusieurs puces semi-conductrices (qui comportent chacune un ou plusieurs composants électroniques de puissance) sont disposées, et qui comprend l'ensemble des éléments remplissant les fonctions d'isolation électrique interne et externe, de connexion électrique entre le ou les composants et le circuit extérieur, de connexion thermique afin de permettre l'évacuation de la chaleur produite par le ou les composants en fonctionnement, de tenue mécanique et de protection physique de la ou des puces semi-conductrices.

Les packages les plus utilisés en électronique de puissance sont les packages 2D, appelés aussi packages planaires. Dans un package 2D, la ou les faces arrières de la ou des puces semi-conductrices sont reportées par brasure ou frittage sur un substrat, ou support métallisé formé par un empilement de plusieurs couches de matériaux différents (conducteurs et diélectriques), comme par exemple un substrat DBC (« Direct Bonded Copper » selon la terminologie anglo-saxonne). Le substrat assure les connexions électriques, la tenue mécanique de la ou des puces semi-conductrices reportées sur le substrat et fournit les moyens pour la liaison avec le système de refroidissement. La connexion électrique en face avant des puces électroniques de puissance est assurée par l'intermédiaire de fils de bonding ou de rubans de connexion. Enfin, un capot recouvre le substrat ainsi que la ou les puces semi-conductrices. Des lyres ou un lead frame (également appelé cadre conducteur) interconnectent les potentiels à l'intérieur du module avec l'extérieur du package.

Un tel package 2D présente plusieurs inconvénients :
- le refroidissement de la ou des puces semi-conductrices n'est assuré que depuis une seule face (la face arrière) de la ou des puces semi-conductrices à cause de la présence des fils de bonding ou des rubans de connexion en face avant de cette ou ces puces semi-conductrices ;
- les fils de bonding, les rubans de connexions, les lires et le lead frame induisent des inductances parasites de câblage qui limitent les performances d'un module électronique de puissance formé avec un tel package ;
- d'un point de vue électromagnétique, étant donné que tous les contacts électriques du substrat reliés à la ou aux puces semi-conductrices sont présents sur la face avant du substrat, des chemins de perturbations conduites de mode commun (du circuit vers la masse) sont générés par l'intermédiaire de capacités parasites formées entre ces contacts électriques du substrat et la semelle du substrat, généralement connectée à la masse ;
- ce type d'assemblage comporte plusieurs matériaux (Cu, Al, Si, céramiques, brasures) proches les uns des autres qui ont des CTE (coefficient de dilatation thermique) différents. Lors des différents cycles thermiques appliqués au module, il subit donc de fortes déformations limitant sa durée de vie, comme par exemple : décollement du cuivre du substrat DBC, fissuration de la céramique du substrat, décollement et fissuration des fils de bonding, délamination ou fissuration de la brasure (le plus souvent dans les angles car les sollicitations mécaniques y sont les plus importantes, du fait que les puces semi-conductrices sont généralement découpées sous la forme de rectangles (ou carrés) et que la surface de la brasure correspond à celle des puces).

Ainsi, nonobstant la bonne maturité technologique du packaging 2D, ces limites électriques, électromagnétiques, thermiques et thermomécaniques motivent le développement d'autres approches de packaging visant à améliorer les performances des modules électroniques de puissance.

Un autre type de packaging, appelé packaging 3D, propose de réaliser le même empilement de brasure, substrat, système de refroidissement que celui utilisé pour les packages 2D, mais réparti sur les deux faces des puces semi-conductrices. Afin de rendre possible un tel assemblage, plusieurs familles d'interconnections en face avant ont été développées afin de remplacer les fils de bonding : contacts pressés, brasés, par ressorts, des bumps, ou encore des clips en cuivre. Un tel packaging apporte des bénéfices en termes de performances thermiques et de compatibilité électromagnétique. Néanmoins, un tel packaging demande l'ajout de matière de type brasure contre les puces semi-conductrices et un traitement supplémentaire de la surface des puces semi-conductrices afin de les adapter à ce type de prise de contact, ce qui réduit les performances thermomécaniques du module. De plus, un tel packaging est adapté pour être mis en oeuvre à l'échelle de la puce, c'est-à-dire réalisé de manière unitaire pour chaque puce, et la mise en oeuvre d'un procédé d'assemblage collectif réalisé simultanément pour plusieurs puces semi-conductrices est difficile avec un tel packaging. Enfin, ce packaging n'apporte pas de solution à la faible fiabilité thermomécanique des modules électroniques de puissance liée à leur sensibilité aux cycles thermiques à cause de la différence de CTE des différents matériaux qui constituent le module électronique de puissance et au nombre croissant de couches empilées pour réaliser les interconnexions.

EP 2 244 288 A1 décrit un packaging 3D.

### EXPOSÉ DE L'INVENTION

Un but de la présente invention est de proposer un packaging améliorant au moins une partie des propriétés électromagnétiques, thermiques, électriques et thermomécaniques d'un module électronique de puissance par rapport aux packagings de l'art antérieur précédemment décrits.

Pour cela, la présente invention concerne un module électronique de puissance comportant au moins :
- une puce semi-conductrice comprenant au moins un composant électronique de puissance ;
- deux couches métalliques entre lesquelles la puce semi-conductrice est directement solidarisée, et, optionnellement, telles qu'au moins une première des deux couches métalliques forme une couche de redistribution comprenant plusieurs portions métalliques distinctes chacune reliée électriquement à au moins un plot de contact électrique de la puce semi-conductrice, et telles qu'au moins une deuxième des deux couches métalliques comporte au moins une première face structurée disposée contre la puce semi-conductrice et comprenant au moins un plot formé dans une partie de son épaisseur.

La puce semi-conductrice est disposée et directement solidarisée entre les deux couches métalliques, sans aucun apport de matière supplémentaire entre la puce semi-conductrice et chacune des deux couches métalliques par un procédé de collage direct (assisté ou non par thermocompression). Cela permet de rendre plus robuste les connexions électriques de cette puce, ainsi que les interconnexions électriques entre les composants électroniques de puissance lorsque la puce semi-conductrice comporte plusieurs composants électroniques de puissance et/ou lorsque le module électronique de puissance comporte plusieurs puces semi-conductrices directement solidarisées aux deux couches métalliques.

La métallisation en surface de la puce semi-conductrice est de même nature que celle du ou des métaux formant les deux couches métalliques.

La solidarisation directe entre les couches métalliques et la puce semi-conductrice contribue également à améliorer le comportement électromagnétique du module électronique de puissance car les connexions électriques reliées à la puce semi-conductrice ne sont plus réalisées par des fils de bonding ou des rubans de connexion, ce qui évite d'induire des inductances parasites de câblage.

Le comportement thermique et thermomécanique du module électronique de puissance est également amélioré grâce au fait qu'aucun matériau de brasure n'est présent entre chacune des deux couches métalliques et la puce semi-conductrice. L'absence de brasure en contact avec la puce semi-conductrice permet d'éviter les défaillances de la puce dues à cette brasure, notamment lorsque la puce semi-conductrice est soumise à des variations de température importantes.

Les deux couches métalliques peuvent être formées à partir de plaques métalliques massives structurées en 3D.

La structuration en 3D des couches métalliques permet d'éviter d'avoir à mettre en oeuvre une étape de dépôt électrochimique, ou ECD, pour former la couche de redistribution en surface de la puce semi-conductrice, ce qui simplifie la réalisation de la structure et permet également de réaliser facilement des motifs de redistribution différents d'une puce à l'autre lorsque plusieurs modules électroniques de puissance sont réalisés de manière collective à partir de deux plaques métalliques servant à la réalisation des deux couches métalliques de chacun des modules électroniques de puissance.

De plus, les éléments de connexion formés par les portions métalliques de la première des deux couches métalliques sont aptes à faire passer des courants bien supérieurs à ceux pouvant traverser des interconnexions formées de manière classique par ECD dans le cadre des couches de redistribution. Les portions métalliques de la couche de redistribution peuvent former des contacts et des interconnexions à forts calibres en courant et qui peuvent être reportés au plus près du ou des composants électroniques de puissance du module. Les formes des portions métalliques de la couche de redistribution peuvent être totalement maîtrisées, ce qui rend le comportement CEM (compatibilité électromagnétique) conduit et rayonné de cette couche de redistribution totalement optimal en réduisant au maximum les effets capacitifs (par exemple grâce à l'absence de reprises de contact sur un support métallisé tel qu'un substrat DBC pour interconnecter les points milieux de cellules formées par les composants électroniques de puissance) et magnétiques, les portions métalliques pouvant former des pistes conductrices courtes et proches de la ou des puces semi-conductrices, réduisant ainsi les tailles des mailles de commutation et évitant des boucles avec reprise de contact sur le support métallisé.

La première des deux couches métalliques peut réaliser à la fois la distribution et l'interconnexion des plots de contact électrique de la puce semi-conductrice, dans un seul et même niveau.

La puce semi-conductrice et les deux couches métalliques entre lesquelles la puce semi-conductrice est disposée forment un assemblage dont la structure est symétrique. Cette symétrie permet de ne pas créer de déformation lors de la solidarisation des deux couches métalliques contre la puce semi-conductrice.

Les couches métalliques disposées de chaque côté de la puce semi-conductrice permettent d'envisager de nouvelles configurations dans la conception du module, étant donné les degrés de liberté donnés par la possibilité de structurer les couches métalliques.

En outre, la face structurée de la deuxième des deux couches métalliques qui comporte le ou les plots disposés contre l'une des faces de la puce semi-conductrice, par exemple contre la face avant de la puce semi-conductrice, contribue à l'amélioration du comportement thermique et thermomécanique du module, notamment via la possibilité d'utiliser aussi cette face de la puce semi-conductrice pour assurer son refroidissement.

La première des deux couches métalliques peut former des interconnexions entre plusieurs composants électroniques de la puce et/ou entre plusieurs puces semi-conductrices, et/ou former des zones de report ou de reprise de contacts de plus grandes dimensions que les plots de contact électrique de la puce semi-conductrice, et/ou former des surfaces d'échange thermique plus importantes que celles formées par la puce semi-conductrice.

La structure de ce module électronique de puissance est également compatible avec une réalisation collective, c'est-à-dire simultanée à l'échelle d'une plaque comportant des composants électroniques de puissance, ou entre deux plaques comportant des composants électroniques de puissance pour former des cellules de commutation en 3D basées sur l'empilement des puces semi-conductrices l'une sur l'autre.

La puce semi-conductrice peut comporter avantageusement du GaN. Dans ce cas, le ou les composants électroniques de puissance de cette puce semi-conductrice ont avantageusement une structure dite latérale, ce qui signifie que la zone active et les électrodes de ce ou ces composants sont localisées au niveau d'une seule face (face avant) du ou des composants. Le courant de puissance circule intégralement dans cette zone très fine (souvent d'épaisseur inférieure à environ 10 µm), ce qui implique une importante densité de puissance et donc un besoin de refroidissement important. Le packaging du module électronique de puissance proposé ici est bien adapté à de tels composants du fait que sa structure est compatible avec un refroidissement réalisé au niveau des deux faces principales de la ou des puces semi-conductrices. Un refroidissement peut toutefois être réalisé au niveau des deux faces principales de la ou des puces semi-conductrices même lorsque la puce semi-conductrice comporte un semi-conducteur autre que du GaN.

Les composants à base de GaN ont des dynamiques de commutation de plusieurs centaines de volts et de dizaine d'ampères par nanoseconde. Le packaging du module électronique de puissance proposé ici conduit à un comportement CEM conduit et rayonné optimisé adapté à de telles contraintes.

Au moins la première des deux couches métalliques peut assurer l'interconnexion des composants électroniques de puissance à l'échelle du substrat à partir duquel ces composants sont réalisés, ou à l'échelle d'un bloc de composants, répartis dans une ou plusieurs puces semi-conductrices. Ainsi, en plus des avantages électromagnétiques et thermiques apportés par les deux couches métalliques, cette configuration permet d'optimiser l'intégration système des composants latéraux.

L'utilisation d'une couche métallique épaisse pour former la couche de redistribution permet de renforcer/élargir les plages d'accueil et les prises de contact de chaque électrode de puissance du ou des composants. Cette prise de contact, par ajout de matière, assure une liaison optimale entre le dernier niveau de métal coté composant(s) et la reprise de contact entre les composants et leur environnement.

Le ou les plots formés par la face structurée de la deuxième couche métallique assurent non seulement la tenue mécanique du module mais permettent également de relâcher les contraintes induites par la différence de CTE entre le semi-conducteur de la puce et un substrat, par exemple de type DBC, sur lequel la deuxième des deux couches métalliques peut être disposée. Il est possible de réaliser les plots avec une densité, une hauteur et un rayon de courbure plus ou moins importants afin d'optimiser la distribution des contraintes induites par la différence de CTE et par le flux de chaleur auquel la puce peut être exposée.

La première face structurée de la deuxième des deux couches métalliques disposée contre la puce semi-conductrice peut former, dans une partie seulement de son épaisseur, au moins deux plots distincts disposés contre la puce semi-conductrice.

Dans un mode de réalisation avantageux, la première et/ou la deuxième des deux couches métalliques peut avoir une épaisseur supérieure à environ 100 µm et/ou peut comporter du cuivre. Une telle épaisseur ne peut pas être obtenue, avec des coûts raisonnables, par les procédés de type ECD.

Les plots de contact électrique de la ou des puces semi-conductrices comportent un ou plusieurs métaux similaire(s) à celui ou ceux d'au moins la première des deux couches métalliques, par exemple du cuivre, ce qui facilite le collage direct entre au moins la première des deux couches métalliques et la puce semi-conductrice.

Le module électronique de puissance comporte en outre un premier support métallisé auquel la deuxième des deux couches métalliques est solidarisée. Le CTE du premier support métallisé peut être proche ou similaire de celui de la deuxième des deux couches métalliques. Ainsi lors de cette solidarisation, la puce semi-conductrice est soumise à peu de sollicitations thermomécaniques. La deuxième des deux couches métalliques peut être solidarisée au premier support métallisé par exemple par l'intermédiaire d'une première couche de brasure. Cette première couche de brasure est dans ce cas peu contrainte en raison des CTE proches ou similaires des matériaux du premier support métallisé et de la deuxième des deux couches métalliques.

De manière avantageuse, le plot ou chacun des plots de la première face structurée de la deuxième des deux couches métalliques peut comporter une section, dans un plan passant par ladite première face structurée, dont la forme inclut des coins arrondis ou est de forme sensiblement circulaire. Cette forme de plots permet de réduire les contraintes thermomécaniques subies par la puce semi-conductrice. D'autres formes de plots sont également possibles.

Une deuxième face, opposée à la première face structurée, de la deuxième des deux couches métalliques peut comporter un bord délimitant latéralement un espace dans lequel est disposée la première couche de brasure. Ce bord permet notamment de protéger les flancs latéraux de la puce semi-conductrice lors de la solidarisation entre la deuxième des deux couches métalliques et le premier support métallisé, qui comporte par exemple un substrat DBC, en évitant un débordement de la brasure issue de cette première couche de brasure.

L'une ou chacune des deux couches métalliques peut comporter une couche centrale comprenant au moins un premier métal et qui est recouverte d'une autre couche d'au moins un deuxième métal différent du premier métal et contre laquelle la puce semi-conductrice est solidarisée. Ainsi, le premier métal peut être choisi pour certaines propriétés, par exemple thermiques (le matériau de la couche centrale peut par exemple être choisi tel qu'il favorise le transport de la chaleur et du courant), bien qu'il ne soit par exemple pas adapté pour être solidarisé directement avec la puce semi-conductrice, ce collage direct étant assuré par le deuxième métal. Dans cette configuration, l'une ou chacune des deux couches métalliques peut être formée de plusieurs métaux superposés, obtenus par exemple par laminage, ce qui permet par exemple de choisir, pour le matériau contre lequel la puce semi-conductrice est solidarisée, un CTE adapté à celui des matériaux de la puce semi-conductrice, contribuant ainsi à l'adaptation des CTE des différents éléments du module.

La première des deux couches métalliques peut comporter une deuxième face, opposée à une première face disposée contre la puce semi-conductrice, solidarisée au moins à un deuxième substrat métallisé et/ou à des lyres de puissance et/ou à une capacité de découplage et/ou à un dispositif électronique de commande.

Le deuxième substrat métallisé peut servir ainsi à réaliser un refroidissement double face de la puce semi-conductrice.

Les lyres de puissance ainsi disposées permettent d'éviter les reprises de contact depuis un support métallisé tel qu'un substrat DBC et suppriment les boucles de courant formées dans les modules de l'art antérieur qui comportent des fils de bonding ou des rubans de connexion. Il est donc possible qu'aucun potentiel flottant ne soit reporté sur le substrat DBC, ce qui limite les chemins de propagation parasites de type capacitif formés dans le module électronique de puissance.

La première des deux couches métalliques peut comporter une première face structurée disposée contre la puce semi-conductrice et comprenant des plots formés dans une partie de son épaisseur.

Le module électronique de puissance peut comporter au moins une deuxième puce semi-conductrice comprenant au moins un deuxième composant électronique de puissance et disposée directement entre les deux couches métalliques. Dans ce cas, le module électronique de puissance forme un module électronique de puissance comprenant plusieurs puces semi-conductrices solidarisées directement aux deux couches métalliques.

L'invention porte également sur un procédé de réalisation d'au moins un module électronique de puissance, comportant au moins la mise en oeuvre des étapes suivantes :
- réalisation, à partir d'au moins une première de deux couches métalliques, d'une couche de redistribution comprenant plusieurs portions métalliques distinctes, et/ou structuration d'au moins une première face d'une deuxième des deux couches métalliques, formant des plots dans une partie de son épaisseur ;
- solidarisation par collage direct d'une puce semi-conductrice comprenant au moins un composant électronique de puissance entre les deux couches métalliques, telle que chacune des portions métalliques de la première des deux couches métalliques soit reliée électriquement à au moins un plot de contact électrique de la puce semi-conductrice et/ou telle que la première face structurée de la deuxième des deux couches métalliques soit disposée contre la puce semi-conductrice.

La solidarisation par collage direct de la puce semi-conductrice entre les deux couches métalliques peut comporter la mise en oeuvre d'une thermocompression des deux couches métalliques contre la puce semi-conductrice. Une telle thermocompression peut être ou non mise en oeuvre selon les états de surface de la puce semi-conductrice et des deux couches métalliques.

Le procédé comporte en outre la mise en oeuvre d'une étape de solidarisation, par l'intermédiaire d'une première couche de brasure, entre la deuxième des deux couches métalliques du module électronique de puissance et un premier support métallisé comme par exemple une substrat de type DBC. Une telle solidarisation avec un autre support métallisé peut également être réalisée du côté de la première des deux couches métalliques du module électronique de puissance

La solidarisation par collage direct de la puce semi-conductrice entre les deux couches métalliques peut correspondre à une solidarisation par collage direct d'un premier substrat formant une matrice de puces semi-conductrices entre deux deuxièmes substrats métalliques destinés à former chacun l'une des deux couches métalliques. Dans ce cas, le procédé de réalisation est avantageusement mis en oeuvre à l'échelle du substrat, ou wafer qui comporte les composants électroniques de puissance, pour réaliser simultanément plusieurs modules électroniques de puissance et réaliser notamment simultanément l'ensemble des interconnexions entre plusieurs composants électroniques de puissance réalisées dans une matrice, à partir d'un même substrat semi-conducteur. Une telle mise en oeuvre collective permet de rendre plus fiable la réalisation des modules électroniques de puissance. Dans cette configuration, trois wafers ou substrats sont assemblés pour former des empilements symétriques. Les substrats utilisés sont de deux types : substrat semi-conducteur contenant une matrice de composants de puissance unitaires ou monolithique (matrice de puces comprenant chacune un ou plusieurs composants électroniques de puissance) et substrats métalliques structurés pour former les couches métalliques auxquelles les puces seront reliées. Les deux types de substrats sont conçus pour être assemblés de manière appropriée, sans apport de matière avec un procédé de collage par thermocompression. Les états de surface des substrats ainsi que les positions respectives des contacts sont conçus et réalisés de manière adéquate (vis-à-vis des contacts, tailles et positions des contacts, état de surface et matériaux des contacts).

Le procédé peut comporter en outre, après l'étape de solidarisation, la mise en oeuvre d'une étape de découpe des premier et deuxièmes substrats, formant plusieurs modules électroniques de puissance comportant chacun au moins une des puces semi-conductrices solidarisée directement aux deux couches métalliques.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un module électronique de puissance, objet de la présente invention, selon un premier mode de réalisation ;
- les figures 2A et 2B représentent un exemple de réalisation de plots formés en surface d'une des deux couches métalliques d'un module électronique de puissance, objet de la présente invention ;
- la figure 3 représente un module électronique de puissance, objet de la présente invention, selon un deuxième mode de réalisation ;
- la figure 4 représente un exemple de réalisation d'une des deux couches métalliques du module électronique de puissance, objet de la présente invention, selon le deuxième mode de réalisation ;
- la figure 5 représente un module électronique de puissance, objet de la présente invention, selon un troisième mode de réalisation ;
- les figures 6 et 7 représentent deux variantes de réalisation du module électronique de puissance, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

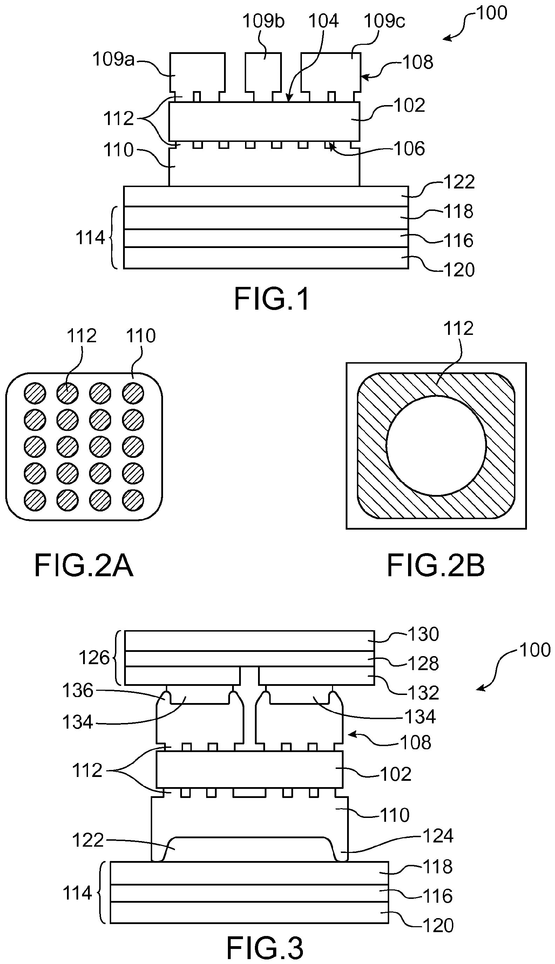

On se réfère tout d'abord à la figure 1 qui représente un module électronique de puissance 100, ou module électronique de puissance, selon un premier mode de réalisation.

Le module 100 comporte une puce semi-conductrice 102 dans laquelle sont formés un ou plusieurs composants électroniques de puissance. Ce ou ces composants électroniques de puissance correspondent par exemple à des diodes, des transistors ou encore des thyristors. La puce 102 comporte des première et deuxième faces principales respectivement référencées 104 et 106. La puce 102 comporte également des plots de contact électrique présents au niveau de la première face principale 104 et/ou de la deuxième face principale 106 (au niveau de ces deux faces principales si le ou les composants électroniques de puissance ont chacun une structure verticale). Les plots de contact électrique de la puce 102 sont reliés à des zones actives du ou des composants électroniques de puissance de la puce 102. Ces plots de contact électrique de la puce 102 comportent par exemple du cuivre, de l'AlCu ou encore du titane ou tout autre matériau métallique.

Le module 100 comporte également des première et deuxième couches métalliques 108, 110 chacune directement solidarisée à l'une des première et deuxième faces principales 104, 106 de la puce 102, c'est-à-dire sans matériau intermédiaire pour réaliser l'étape de collage (notamment de la brasure) interposé entre les couches métalliques 108, 110 et les faces 104, 106 de la puce 102. L'épaisseur de chacune des couches métalliques 108, 110 est par exemple supérieure à environ 100 µm, et par exemple égale à plusieurs centaines de microns. Les couches métalliques 108, 110 comportent avantageusement du cuivre.

Au moins l'une des deux couches métalliques 108, 110 forme une couche de redistribution, c'est-à-dire qui est structurée telle qu'elle forme plusieurs portions métalliques distinctes et reliées électriquement aux plots de contact électrique de la puce 102.

Selon une première configuration, les plots de contact électrique de la puce 102 peuvent être disposés au niveau d'une seule des deux faces 104, 106. C'est le cas sur l'exemple de réalisation représenté sur la figure 1 où tous les plots de contact électrique de la puce 102 sont disposés du côté de la face principale 104. Dans ce cas, seule l'une des deux couches métalliques 108, 110 forme une couche de redistribution reliée à ces plots de contact électrique (la première couche 108 sur l'exemple de réalisation représenté sur la figure 1). Selon une deuxième configuration, les plots de contact électrique de la puce 102 peuvent être disposés au niveau des deux faces 104, 106. Dans ce cas, les deux couches 108, 110 forment des couches de redistribution reliées à ces plots de contact électrique.

La ou les couches métalliques servant de couches de redistribution peuvent être structurées pour former des portions métalliques distinctes chacune reliée à un ou plusieurs des plots de contact électrique de la puce 102. Sur l'exemple de réalisation représenté sur la figure 1, la couche 108, servant de couche de redistribution, est structurée de manière à former plusieurs portions distinctes chacune reliée à un ou plusieurs plots de contact électrique de la puce 102 distincts du ou des autres plots auxquels les autres portions de la couche 108 sont reliées. Sur l'exemple de la figure 1, trois portions distinctes 109a, 109b et 109c la couche 108 sont représentées. Pour former ces portions 109 distinctes les unes des autres, la première couche métallique 108 est structurée, par exemple gravée, sur toute son épaisseur. Des tranchées séparant ces différentes portions 109 traversent toute l'épaisseur de la couche 108.

De plus, dans le premier mode de réalisation décrit ici, la face de chacune des couches métallique 108, 110 qui se trouve du côté de la puce 102 est également structurée afin de former des plots 112 en contact avec la puce 102. Ces plots 112 sont formés dans une partie de l'épaisseur des couches métalliques 108, 110.

La figure 2A représente un premier exemple de réalisation des plots 112. Cette figure représente une vue de dessus de la deuxième couche métallique 110, la face supérieure de cette couche 110 étant structurée en formant des plots dans une partie de l'épaisseur de la couche 110. Sur cet exemple, chacun des plots 112 comprend une section, dans un plan passant par cette face supérieure de la couche 110, de forme sensiblement circulaire. Sur cette figure 2A, des hachures représentent les surfaces des plots en contact avec la puce 102.

La figure 2B représente une autre variante de réalisation avec un seul plot massif 112 au niveau de la couche 110. Là encore, des hachures représentent la surface du plot 112 en contact avec la puce 102. Selon une variante de réalisation, les plots 112 peuvent comporter une section dont la forme inclut des coins arrondis avec un rayon de courbure pouvant varier, ce qui permet d'optimiser les contraintes mécaniques dues aux angles.

L'ensemble formé par la puce 102 et les couches métalliques 108, 110 est reporté sur la face avant d'un support métallisé 114 correspondant ici à un substrat DBC formé d'une couche centrale diélectrique 116, comprenant par exemple une céramique, disposée entre une couche métallique supérieure 118 et une couche métallique inférieure 120, par exemple à base de cuivre. La solidarisation entre cet ensemble et le support métallisé 114, et plus précisément entre la couche métallique 110 et la couche métallique supérieure 118, est assurée par une couche de brasure 122.

Bien que non visible sur la figure 1, le support métallisé 114 peut être solidarisé, au niveau de sa face arrière et par l'intermédiaire d'une autre couche de brasure, à un ensemble de refroidissement comprenant par exemple une semelle métallique, ou « spreader » selon la terminologie anglo-saxonne, et un dissipateur thermique reliés l'un à l'autre par une graisse thermique.

Le module électronique de puissance 100 selon un deuxième mode de réalisation est représenté sur la figure 3.

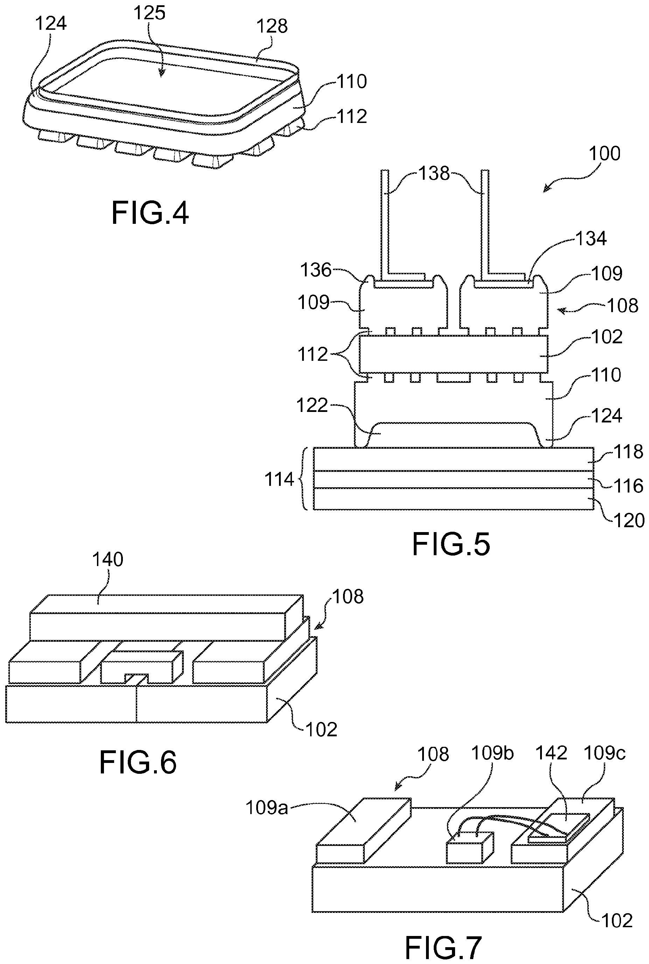

Dans ce deuxième mode de réalisation, la deuxième couche métallique 110 comporte, au niveau de sa face arrière (celle se trouvant du côté du support métallisé 114), un bord 124 délimitant latéralement un espace 125 (visible sur la figure 4) dans lequel est disposée la couche de brasure 122. La figure 4 représente de manière plus détaillée la deuxième couche métallique 110. Le bord 124 est recouvert d'un matériau diélectrique 128 permettant de contenir la brasure de la couche 122 de par sa faible mouillabilité par la brasure. Ce matériau diélectrique 128 est par exemple un oxyde ou un vernis. Dans cette configuration, on évite le risque que le matériau de brasure ne vienne perturber le bon fonctionnement de la puce 102 après la solidarisation de la deuxième couche métallique 110 avec le support métallisé 114.

En outre, dans ce deuxième mode de réalisation, un deuxième substrat métallisé 126 est solidarisé à la face arrière (celle se trouvant du côté opposé à la puce 102) de la première couche métallique 108. Ce deuxième substrat métallisé 126 correspond par exemple à un substrat DBC formé, comme le premier substrat métallisé 114, d'une couche centrale diélectrique 128 disposée entre deux couches métalliques 130 et 132. La solidarisation entre la face arrière de la première couche métallique 108 et le support métallisé 126, et plus précisément entre les couches métalliques 108 et 132, est assurée par une couche de brasure 134. Dans l'exemple de réalisation décrit ici, la couche métallique 108 (ou plus précisément une ou plusieurs des différentes portions métalliques formées par la couche 108) comporte, au niveau de sa face arrière, un bord 136 délimitant latéralement un espace dans lequel est disposée la couche de brasure 134, de manière analogue à la couche métallique 110. Dans cet exemple de réalisation, le refroidissement de la puce électronique peut être réalisé en double face en solidarisant un système de refroidissement (non visible sur la figure) avec les deux supports métallisés 114 et 126.

Le module électronique de puissance 100 selon un troisième mode de réalisation est représenté sur la figure 5.

Par rapport au deuxième mode de réalisation précédemment décrit, la face arrière de la première couche métallique 108 n'est pas solidarisée à un deuxième substrat métallisé, mais à des lyres de puissance 138, au niveau d'une partie des portions distinctes 109 de la couche métallique 108. La solidarisation entre les lyres de puissance 138 et les faces arrières des portions 109 de la couche métallique 108 est assurée par la couche de brasure 134, ici séparée en plusieurs portions distinctes sur les différentes portions de la couche métallique 108 pour assurer la solidarisation de chacune des lyres de puissance 138.

Selon une autre variante de réalisation représentée sur la figure 6, la face arrière de la première couche métallique 108 peut servir de support à un condensateur de découplage 140 relié électriquement au(x) composant(s) électronique(s) de puissance de la puce 102 par l'intermédiaire de la première couche métallique 108.

Selon une autre variante de réalisation représentée sur la figure 7, la face arrière de la première couche métallique 108 peut servir de support à un circuit de commande 142, ou « driver », relié électriquement au(x) composant(s) électronique(s) de puissance de la puce 102 par l'intermédiaire de la première couche métallique 108. Un tel circuit de commande 142 peut par exemple servir à commander la commutation d'un transistor de puissance formé dans la puce 102. Sur l'exemple de la figure 7, les portions 109a, 109b et 109c formées par la première couche métallique 108 sont reliées respectivement au drain, à la grille et à la source d'un transistor de puissance formé dans la puce 102, le circuit de commande 142 étant disposé sur la portion métallique 109c reliée à la source du transistor de puissance et relié électriquement à la portion métallique 109b qui est reliée à la grille du transistor de puissance pour commander la mise à l'état passant ou bloqué du transistor.

Dans tous les modes de réalisation décrits ici, le ou les composants électroniques de puissance de la puce semi-conductrice 102 peuvent former au moins une cellule de commutation. Le module électronique de puissance 100 peut notamment former un module électronique de puissance comprenant plusieurs puces semi-conductrices 102 formant plusieurs cellules de commutation reliées électriquement entre elles par les deux couches métalliques 108, 110.

On décrit ci-dessous un exemple d'un procédé de réalisation du module électronique de puissance 100. Dans l'exemple décrit ici, le procédé est mis en oeuvre tel que plusieurs modules électroniques de puissance 100 soient réalisés collectivement.

Des composants électroniques de puissance sont tout d'abord réalisés à partir d'un premier substrat semi-conducteur. Les plots de contact de ces composants sont réalisés à partir de cuivre.

Une structuration de deux substrats métalliques est ensuite mise en oeuvre. Cette structuration correspond notamment à la réalisation de perforations traversant tout le ou les substrats destinés à former les couches de redistribution des modules 100, et la réalisation de plots sur une ou les deux faces de l'un ou des deux substrats, dans une partie de l'épaisseur de ce ou ces substrats. De préférence, ces substrats métalliques comportent du cuivre qui est un métal à la fois intéressant pour sa conductivité électrique et sa conductivité thermique. En variante, l'un ou les deux substrats métalliques peuvent comporter une couche centrale à base d'un autre métal (par exemple du tungstène ou du molybdène, éventuellement recouverte d'une couche métallique plus adaptée à la mise en oeuvre d'un collage direct avec les puces semi-conductrices réalisées dans le premier substrat.

De telles plaques métalliques peuvent être obtenues par laminage, détourage, structuration par gravure (suivie éventuellement d'un polissage), et gravure traversante pour former les différentes portions métalliques distinctes.

Un collage direct est ensuite mise en oeuvre afin d'assembler les trois substrats par collage direct. Le substrat semi-conducteur est disposé entre les deux substrats métalliques. Lorsque la rugosité des surfaces collées est inférieure ou égale à environ 0,5 nm RMS, le collage direct peut être mis en oeuvre à température ambiante sans appliquer de pression entre les éléments collés. Lorsque la rugosité des surfaces collées est supérieure à cette valeur, et par exemple entre environ 0,5 nm RMS et 100 nm RMS, une thermocompression (pression par exemple de quelques MPa et température contrôlée par exemple entre [300-400]°C pendant le collage) peut être mise en oeuvre pendant le collage.

L'assemblage obtenu après ce collage est ensuite complètement passivé, par exemple en injectant un matériau de passivation dans l'assemblage.

L'assemblage réalisé est ensuite découpé afin d'individualiser les différents modules électroniques de puissance 100.

En variante, la passivation peut être réalisée après cette étape de découpe, chaque module 100 étant passivé individuellement.

Les couches métalliques 108, 110 sont ensuite solidarisées aux autres éléments prévus : support métallisé 114, 126, lyres de puissance 138, etc.

## Revendications

1. Module électronique de puissance (100) comportant au moins :
- une puce semi-conductrice (102) comprenant au moins un composant électronique de puissance ;
- deux couches métalliques (108, 110) entre lesquelles la puce semi-conductrice (102) est directement solidarisée, et telles qu'au moins une deuxième (110) des deux couches métalliques comporte au moins une première face structurée disposée contre la puce semi-conductrice (102) et comprenant au moins un plot (112) formé dans une partie de son épaisseur ; et
- un premier support métallisé (114) auquel la deuxième (110) des deux couches métalliques est solidarisée par l'intermédiaire d'une première couche de brasure (122).

2. Module électronique de puissance (100) selon la revendication 1, dans lequel au moins une première (108) des deux couches métalliques forme une couche de redistribution comprenant plusieurs portions métalliques distinctes (109) chacune reliée électriquement à au moins un plot de contact électrique de la puce semi-conductrice (102).

3. Module électronique de puissance (100) selon l'une des revendications précédentes, dans lequel le plot (112) ou chacun des plots (112) de la première face structurée de la deuxième (110) des deux couches métalliques comporte une section, dans un plan passant par ladite première face structurée, dont la forme inclut des coins arrondis ou est sensiblement circulaire.

4. Module électronique de puissance (100) selon l'une des revendications précédentes, dans lequel une deuxième face, opposée à la première face structurée, de la deuxième (110) des deux couches métalliques comporte un bord (124) délimitant latéralement un espace (125) dans lequel est disposée la première couche de brasure (122).

5. Module électronique de puissance (100) selon l'une des revendications précédentes, dans lequel la première et/ou la deuxième des deux couches métalliques (108, 110) a une épaisseur supérieure à environ 100 µm et/ou comporte du cuivre.

6. Module électronique de puissance (100) selon l'une des revendications précédentes, dans lequel l'une ou chacune des deux couches métalliques (108, 110) comporte une couche centrale comprenant au moins un premier métal et recouverte d'une autre couche d'au moins un deuxième métal différent du premier métal et contre laquelle la puce semi-conductrice (102) est solidarisée.

7. Module électronique de puissance (100) selon l'une des revendications précédentes, dans lequel la première (108) des deux couches métalliques comporte une deuxième face, opposée à une première face disposée contre la puce semi-conductrice (102), solidarisée au moins à un deuxième substrat métallisé (126) et/ou à des lyres de puissance (138) et/ou à une capacité de découplage (140) et/ou à un dispositif électronique de commande (142).

8. Module électronique de puissance (100) selon l'une des revendications précédentes, dans lequel la première (108) des deux couches métalliques comporte une première face structurée disposée contre la puce semi-conductrice (102) et comprenant des plots (112) formés dans une partie de son épaisseur.

9. Module électronique de puissance (100) selon l'une des revendications précédentes, comportant au moins une deuxième puce semi-conductrice (102) comprenant au moins un deuxième composant électronique de puissance et disposée directement entre les deux couches métalliques (108, 110).

10. Procédé de réalisation d'au moins un module électronique de puissance (100), comportant au moins la mise en oeuvre des étapes suivantes :
- réalisation de deux couches métalliques, incluant une structuration d'au moins une première face d'une deuxième (110) des deux couches métalliques, formant au moins un plot (112) dans une partie de son épaisseur ;
- solidarisation par collage direct d'une puce semi-conductrice (102) comprenant au moins un composant électronique de puissance entre les deux couches métalliques (108, 110), telle que la première face structurée de la deuxième (110) des deux couches métalliques soit disposée contre la puce semi-conductrice (102) ;
- solidarisation, par l'intermédiaire d'une première couche de brasure (122), entre la deuxième (110) des deux couches métalliques du module électronique de puissance (100) et un premier support métallisé (114).

11. Procédé selon la revendication 10, dans lequel la première (108) des deux couches métalliques est réalisée telle qu'elle forme une couche de redistribution comprenant plusieurs portions métalliques distinctes (109), et dans lequel la puce semi-conductrice (102) est solidarisée à la première (108) des deux couches métalliques telle que chacune des portions métalliques (109) soit reliée électriquement à au moins un plot de contact électrique de la puce semi-conductrice (102).

12. Procédé selon l'une des revendications 10 ou 11, dans lequel la solidarisation par collage direct de la puce semi-conductrice (102) entre les deux couches métalliques (108, 110) comporte la mise en oeuvre d'une thermocompression des deux couches métalliques (108, 110) contre la puce semi-conductrice (102).

13. Procédé selon l'une des revendications 10 à 12, dans lequel la solidarisation par collage direct de la puce semi-conductrice (102) entre les deux couches métalliques (108, 110) correspond à une solidarisation par collage direct d'un premier substrat formant une matrice de puces semi-conductrices (102) entre deux deuxièmes substrats métalliques destinés à former chacun l'une des deux couches métalliques (108, 110).

14. Procédé selon la revendication 13, comportant en outre, après l'étape de solidarisation par collage direct de la puce semi-conductrice (102) entre les deux couches métalliques (108, 110), la mise en oeuvre d'une étape de découpe des premier et deuxièmes substrats, formant plusieurs modules électroniques de puissance (100) comportant chacun au moins une des puces semi-conductrices (102) solidarisée directement aux deux couches métalliques (108, 110).

## Patentansprüche

1. Elektronisches Leistungsmodul (100), mindestens enthaltend:
- einen Halbleiterchip (102), der mindestens eine elektronische Leistungskomponente umfasst;
- zwei Metallschichten (108, 110), zwischen denen der Halbleiterchip (102) direkt fest verbunden ist, und derart, dass mindestens eine zweite (110) der zwei Metallschichten mindestens eine erste strukturierte Seite enthält, die gegen den Halbleiterchip (102) angeordnet ist und mindestens ein Pad (112) umfasst, das in einem Teil ihrer Dicke gebildet ist; und
- einen ersten metallisierten Träger (114), mit dem die zweite (110) der zwei Metallschichten mittels einer ersten Lötschicht (122) fest verbunden ist.

2. Elektronisches Leistungsmodul (100) nach Anspruch 1, wobei mindestens eine erste (108) der zwei Metallschichten eine Umverteilungsschicht bildet, die mehrere getrennte Metallabschnitte (109) umfasst, die jeweils elektrisch an mindestens ein elektrisches Kontaktpad des Halbleiterchips (102) angeschlossen sind.

3. Elektronisches Leistungsmodul (100) nach einem der vorhergehenden Ansprüche, wobei das Pad (112) oder jedes der Pads (112) der ersten strukturierten Seite der zweiten (110) der zwei Metallschichten eine Sektion in einer Ebene enthält, die durch die erste strukturierte Seite verläuft, dessen Form abgerundete Ecken einschließt oder im Wesentlichen kreisförmig ist.

4. Elektronisches Leistungsmodul (100) nach einem der vorhergehenden Ansprüche, wobei eine zweite Seite, die der ersten strukturierten Seite gegenüberliegt, der zweiten (110) der zwei Metallschichten, eine Kante (124) enthält, die seitlich einen Raum (125) begrenzt, in dem die erste Lötschicht (122) angeordnet ist.

5. Elektronisches Leistungsmodul (100) nach einem der vorhergehenden Ansprüche, wobei die erste und/oder die zweite der zwei Metallschichten (108, 110) eine Dicke von mehr als etwa 100 µm aufweist und/oder Kupfer enthält.

6. Elektronisches Leistungsmodul (100) nach einem der vorhergehenden Ansprüche, wobei eine oder jede der zwei Metallschichten (108, 110) eine Mittelschicht enthält, die mindestens ein erstes Metall umfasst, und mit einer anderen Schicht aus mindestens einem zweiten Metall bedeckt ist, das sich vom ersten Metall unterscheidet, und mit der des Halbleiterchips (102) fest verbunden ist.

7. Elektronisches Leistungsmodul (100) nach einem der vorhergehenden Ansprüche, wobei die erste (108) der zwei Metallschichten eine zweite Seite enthält, die einer ersten Seite gegenüberliegt, und gegen den Halbleiterchip (102) angeordnet ist, und mindestens mit einem zweiten metallisierten Substrat (126) fest verbunden ist und/oder mit Leistungs-Lyren (138) und/oder mit einer Entkopplungskapazität (140) und/oder mit einer elektronischen Steuereinrichtung (142).

8. Elektronisches Leistungsmodul (100) nach einem der vorhergehenden Ansprüche, wobei die erste (108) der zwei Metallschichten eine erste strukturierte Seite enthält, die gegen den Halbleiterchip (102) angeordnet ist, und Pads (112) umfasst, die in einem Teil ihrer Dicke ausgebildet sind.

9. Elektronisches Leistungsmodul (100) nach einem der vorhergehenden Ansprüche, mindestens einen zweiten Halbleiterchip (102) enthaltend, der mindestens eine zweite elektronische Leistungskomponente umfasst, und direkt zwischen den zwei Metallschichten (108, 110) angeordnet ist.

10. Verfahren zur Herstellung von mindestens einem elektronischen Leistungsmodul (100), mindestens die Durchführung der folgenden Schritte enthaltend:
- Herstellen von zwei Metallschichten, einschließlich einer Strukturierung von mindestens einer ersten Seite einer zweiten (110) der zwei Metallschichten, wodurch in einem Teil ihrer Dicke mindestens ein Pad (112) gebildet wird;
- festes Verbinden durch direkte Verklebung eines Halbleiterchips (102), der mindestens eine elektronische Leistungskomponente zwischen den zwei Metallschichten (108, 110) umfasst, so dass die erste strukturierte Seite der zweiten (110) der zwei Metallschichten gegen den Halbleiterchip (102) angeordnet ist;
- festes Verbinden, mittels einer ersten Lötschicht (122), zwischen der zweiten (110) der zwei Metallschichten des elektronischen Leistungsmoduls (100) und einem ersten metallisierten Träger (114).

11. Verfahren nach Anspruch 10, wobei die erste (108) der zwei Metallschichten so hergestellt wird, dass sie eine Umverteilungsschicht bildet, die mehrere verschiedene Metallabschnitte (109) umfasst, und wobei der Halbleiterchip (102) mit der ersten (108) der zwei Metallschichten so fest verbunden ist, dass jeder der Metallabschnitte (109) elektrisch an mindestens ein elektrisches Kontaktpad des Halbleiterchips (102) angeschlossen ist.

12. Verfahren nach einem der Ansprüche 10 oder 11, wobei das feste Verbinden durch direkte Verklebung des Halbleiterchips (102) zwischen den zwei Metallschichten (108, 110) die Durchführung einer Thermokompression der zwei Metallschichten (108, 110) gegen den Halbleiterchip (102) enthält.

13. Verfahren nach einem der Ansprüche 10 bis 12, wobei das feste Verbinden durch direkte Verklebung des Halbleiterchips (102) zwischen den zwei Metallschichten (108, 110) einem festen Verbinden durch direkte Verklebung eines ersten Substrats, das eine Halbleiterchipmatrix (102) zwischen zwei zweiten Metallsubstraten bildet, die dazu bestimmt sind, jeweils eine der zwei Metallschichten (108, 110) zu bilden, entspricht.

14. Verfahren nach Anspruch 13, ferner enthaltend, nach dem Schritt des festen Verbindens durch direkte Verklebung des Halbleiterchips (102) zwischen den zwei Metallschichten (108, 110), die Durchführung eines Schritts der Entkopplung des ersten und zweiten Substrats, der mehrere elektronische Leistungsmodule (100) bildet, die jeweils mindestens einen der Halbleiterchips (102) enthalten, der direkt mit den zwei Metallschichten (108, 110) fest verbunden ist.

## Claims

1. Power electronic module (100) including at least:
- one semiconductor chip (102) comprising at least one power electronic component;
- two metal layers (108, 110) between which the semiconductor chip (102) is directly secured, and such that at least a second (110) of the two metal layers includes at least one first structured face disposed against the semiconductor chip (102) and comprising at least one pad (112) formed in part of the thickness thereof
- a first metallised support (114) to which the second (110) of the two metal layers is secured by means of a first layer of solder (122).

2. Power electronic module (100) according to claim 1, wherein at least a first (108) of the two metal layers forms a redistribution layer comprising a plurality of distinct metal portions (109) each electrically connected to at least one electrical contact pad of the semiconductor chip (102).

3. Power electronic module (100) according to one of the preceding claims, wherein the pad (112) or each of the pads (112) of the first structured face of the second (110) of the two metal layers includes a cross section, in a plane passing through said first structured face, the form of which includes rounded corners or is substantially circular.

4. Power electronic module (100) according to one of the preceding claims, wherein a second face, opposite to the first structured face, of the second (110) of the two metal layers includes a rim (124) laterally delimiting a space (125) wherein the first layer of solder (122) is disposed.

5. Power electronic module (100) according to one of the preceding claims, wherein the first and/or the second of the two metal layers (108, 110) has a thickness greater than approximately 100 µm and/or includes copper.

6. Power electronic module (100) according to one of the preceding claims, wherein one or each of the two metal layers (108, 110) includes a central layer comprising at least a first metal and covered with another layer of at least a second metal different from the first metal and against which the semiconductor chip (102) is secured.

7. Power electronic module (100) according to one of the preceding claims, wherein the first (108) of the two metal layers includes a second face, opposite to a first face disposed against the semiconductor chip (102), secured at least to a second metallised substrate (126) and/or to power contacts (138) and/or to a decoupling capacitor (140) and/or to an electronic control device (142).

8. Power electronic module (100) according to one of the preceding claims, wherein the first (108) of the two metal layers includes a first structured face disposed against the semiconductor chip (102) and comprising pads (112) formed in a part of the thickness thereof.

9. Power electronic module (100) according to one of the preceding claims, including at least one second semiconductor chip (102) comprising at least one second power electronic component and disposed directly between the two metal layers (108, 110).

10. Method for producing at least one power electronic module (100) including at least the implementation of the following steps:
- producing two metallic layers, including the structuring of at least a first face of a second (110) of the two metal layers, forming at least one pad (112) in a part of the thickness thereof;
- securing, by direct bonding, a semiconductor chip (102) comprising at least one power electronic component between the two metal layers (108, 110), so that the first structured face of the second (110) of the two metal layers is disposed against the semiconductor chip (102)
- securing, by means of a first layer of solder (122), between the second (110) of the two metal layers of the power electronic module (100) and a first metallised support (114).

11. Method according to claim 10, wherein the first (108) of the two metallic layers is manufactured such that it forms a redistribution layer comprising several distinct metal portions (109), and wherein the semiconductor chip (102) is secured to the first (108) of the two metallic layers in such a way that each of the metal portions (109) is electrically connected to at least one electrical contact of the semiconductor chip (102).

12. Method according to one of claims 10 or 11, wherein the securing, by direct bonding, of the semiconductor chip (102) between the two metal layers (108, 110) includes performing a thermocompression of the two metallic layers (108, 110) against the semiconductor chip (102).

13. Method according to one of claims 10 to 12, wherein the securing, by direct bonding, of the semiconductor chip (102) between the two metal layers (108, 110) corresponds to a securing, by direct bonding, of a first substrate forming a matrix of semiconductor chips (102) between two second metal substrates intended each to form one of the two metal layers (108, 110).

14. Method according to claim 13, further including, after the securing step by direct bonding of the semiconductor chip (102) between the two metal layers (108, 110), the implementation of a step of cutting the first and second substrates, forming a plurality of power electronic modules (100) each including at least one of the semiconductor chips (102) directly secured to the two metal layers (108, 110).
